# DEMANDE DE BREVET EUROPEEN

(11) **EP 2 669 688 A1**
(43) Date de publication de la demande: **04.12.2013**
(21) Numéro de dépôt: 12356014.6
(22) Date de dépôt: 31.05.2012
(51) Int. Cl.: G01R 19/20

(54) **Dispositif de mesure de courant éléctrique isole du courant à mesurer**

(71) Demandeur: Bergoz Instrumentation S.A.R.L., 01630 Saint Genis Pouilly (FR)
(72) Inventeur: Bergoz, Julien, 01170 Crozet (FR)
(74) Mandataire: Stona, Daniel

(57) **Abrégé**

L'invention concerne un dispositif de mesure de courant électrique continu et alternatif isolé du courant à mesurer présentant une résolution inférieure à 1 mA.

Plus particulièrement, l'invention a trait à un dispositif de mesure de courant électrique isoié du courant à mesurer, capable de mesurer le courant avec une résolution inférieure à 1 mA, en particulier de l'ordre de 1 pA, caractérisé en ce qu'il comprend un seul tore pour la modulation, la perception du flux et la contre-réaction.

L'invention se rapporte également à des utilisations d'un tel dispositif.

## Description

L'invention appartient à la catégorie des dispositifs ou instruments de mesure de courant continu et alternatif en isolation galvanique, dits DCCT, par le principe de démodulation de la seconde harmonique aussi appelé "flux-gate". Elle concerne un dispositif de mesure de courant électrique continu et alternatif isolé du courant à mesurer présentant une résolution inférieure à 1 mA.

Dans son mode de réalisation préféré, le dispositif est capabie de mesurer le courant avec une résolution de l'ordre de 1 µA. Sa dynamique --le rapport entre le courant maximum mesurable et la résolution-- est supérieure à 10 millions, sans commutation de gamme.

L'invention permet une simplicité de fabrication et de réglage ainsi qu'une économie considérable grâce notamment à l'usage d'un seul tore magnétique, ce que l'état de l'art ne permet pas pour la mesure à haute résolution d'un courant électrique continu et alternatif isolé du courant à mesurer.

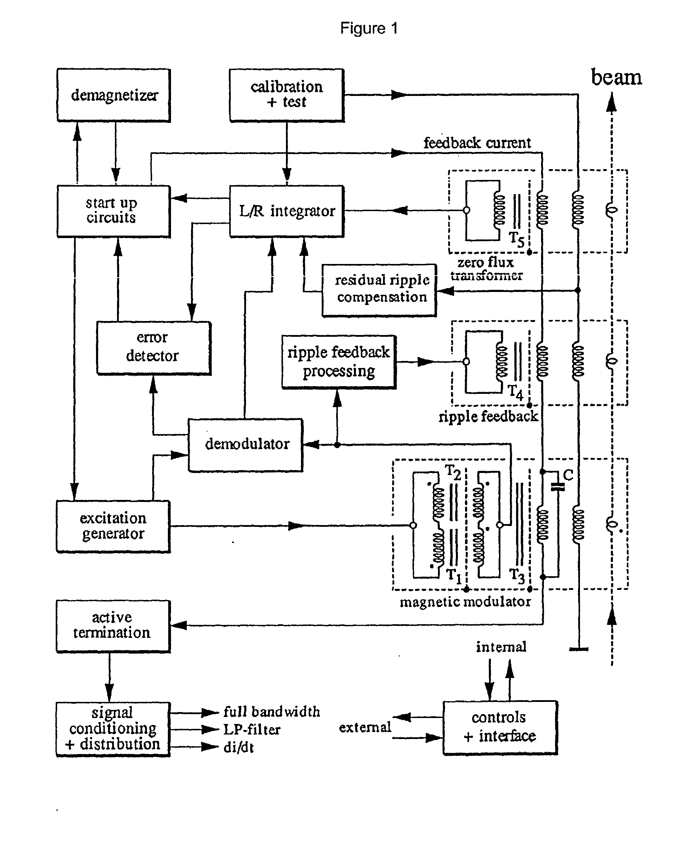

L'état de l'art permet déjà d'obtenir la résolution obtenue par l'invention, mais au prix d'une complexité élevée (cf. New Parametric Current Transformer vendu par la déposante, la Société Bergoz Instrumentation). Le principe et les règles en sont publiés dans 4 communications du CERN de Klaus Unser:
(1) IEEE transactions on nuclear science NS-16, June 1969 pp 934-938
(2) IEEE Transactions on Nuclear Science NS-28, No.3, June 1981, pp 2344-2346
(3) Proceedings IEEE Particle Accelerator Conference, March 1989 Vol.1, pp 71-73
(4) American Institute of Physics Conference proceedings No.252, pp 266-275 Leur schéma de principe "DCCT Unser" est annexé en figure 1.

L'invention est basée sur une application différente de certains principes de physique qui permet une réduction très importante du nombre des composants nécessaire et une relaxation de leur tolérante, donc une baisse du coût de fabrication, tout en permettant de mesurer des courants avec une résolution inférieure à 1 milliampère (mA), voire même de l'ordre de 1 microampère (pA).

L'invention décrite permet d'obtenir une résolution inférieure à 1mA, par exemple de l'ordre de 1 µA avec un seul tore pour la modulation, la perception du flux et la contre-réaction, en rupture avec l'état de l'art qui utilise au moins deux tores pour obtenir une résolution inférieure à 1 mA. La possibilité de mesurer un courant continu avec un seul tore de modulation a déjà été décrite mais ne permet pas d'atteindre une résolution inférieure à 1 mA.

Dans un mode de réalisation, le tore est modulé par une boucle de courant comportant l'enroulement de modulation et au moins un condensateur en série avec ce dernier.

La nécessité d'une saturation profonde des tores de modulation à chaque cycle d'hystérèse pour obtenir une résolution inférieure à 1mA a été démontrée par Unser (publications citées), qui préconise en page 271 de la quatrième référence citée l'usage d'un condensateur dit d'avalanche et défini l'état de l'art. L'invention consiste notamment à obtenir la saturation profonde non pas par un condensateur dit d'avalanche (état de l'art) mais par l'énergie stockée dans l'inductance du ou des tores de modulation.

De plus, l'énergie nécessaire à la saturation du tore magnétique est diminuée par la résonance entre l'inductance du ou des tores et la charge à la fréquence de modulation. Peu importe le facteur de qualité Q du circuit résonant, la diminution de l'énergie requise est obtenue à concurrence de Q.

En d'autres termes, la résonance entre les inductances et capacitances de la boucle de modulation permettent une économie de l'énergie de modulation à concurrence du facteur de qualité de ladite résonance.

Les alliages ferro-magnétiques utilisés pour la fabrication du ou des tores présentent tous une magnétostriction non nulle. De ce fait, l'inductance du ou des tores et en conséquence la valeur mesurée du courant à mesurer varient avec la température. Ce phénomène est largement compensé lorsque deux tores de modulation sont utilisés en phases opposées (état de l'art Unser). Ce n'est pas le cas lorsqu'un seul tore est utilisé.

L'invention revient aussi à corriger --en fonction de la température du ou des tores-- la relation de phase entre le signal issu de l'enroulement de perception du flux et le signal de référence permettant sa démodulation, afin de compenser la dérive de mesure due à la température. Peu importe comment la démodulation du signal est réalisée. Peu importe aussi que le signal à démoduler soit dérivé de l'inductance du tore ou d'un autre dispositif mesurant le flux dans le tore. Peu importe que ie signai soit fiitré ou non, quel que soit le principe de démodulation du signal. Il y a en sorte compensation de la variation de phase due à la variation de température (due à la magnétostriction) lors de la démodulation.

Avantageusement donc, la relation de phase entre le signal issu de l'enroulement de perception du flux et le signal de référence permettant sa démodulation est compensé de la dérive de mesure due à la température.

L'invention permet de simplifier le réglage du dispositif et donc son coût --sans augmentation du bruit de mesure du dispositif-- en remplaçant les filtres Butterworth ajustables préconisés par l'état de l'art par, par exemple, des filtres de Bessel à fréquence fixe.

Le tore est alors modulé par un oscillateur à fréquence ajustable plutôt qu'à fréquence fixe comme l'état de l'art le préconise. Cela entraîne une simplification des réglages et réduction des coûts. Le réglage consiste alors à régler la fréquence de l'oscillateur à la fréquence fixe des filtres de démodulation et non le contraire comme dans l'état de l'art où les nombreux filtres sont réglés en fonction de la fréquence fixe de l'oscillateur.

La fréquence de modulation du tore est alors ajustable.

L'invention permet aussi de supprimer l'intégrateur L/R préconisé par l'état de l'art tout en augmentant ia bande passante du mesure du dispositif, sans préjudice pour la stabilité du dispositif. L'invention adopte des tores dont la section magnétique est très faible, rendant possible l'augmentation de la fréquence de modulation et en conséquence augmentant la bande passante de mesure du dispositif.

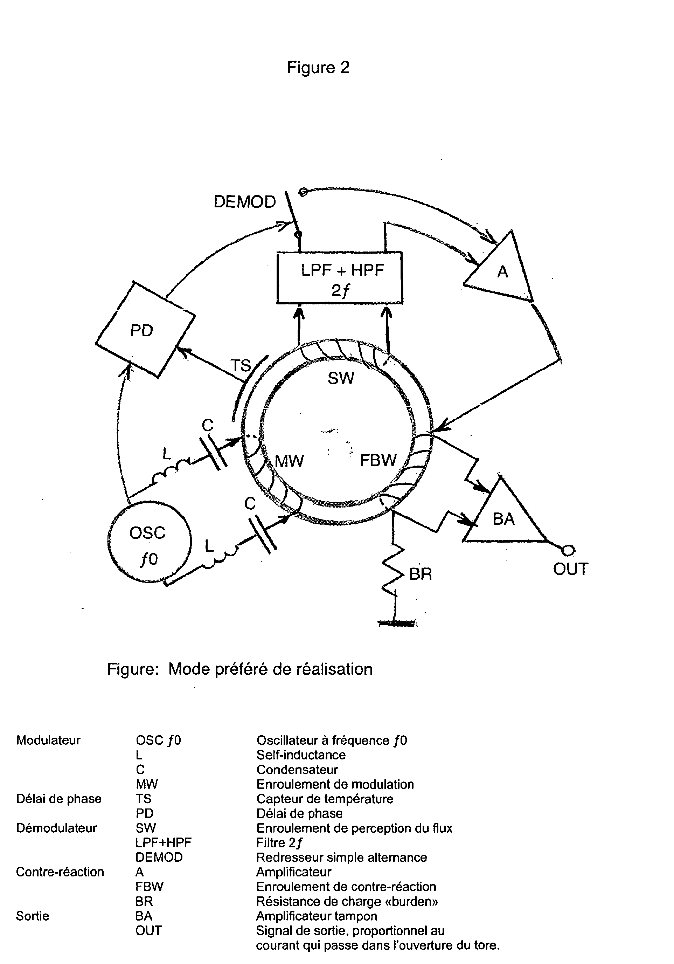

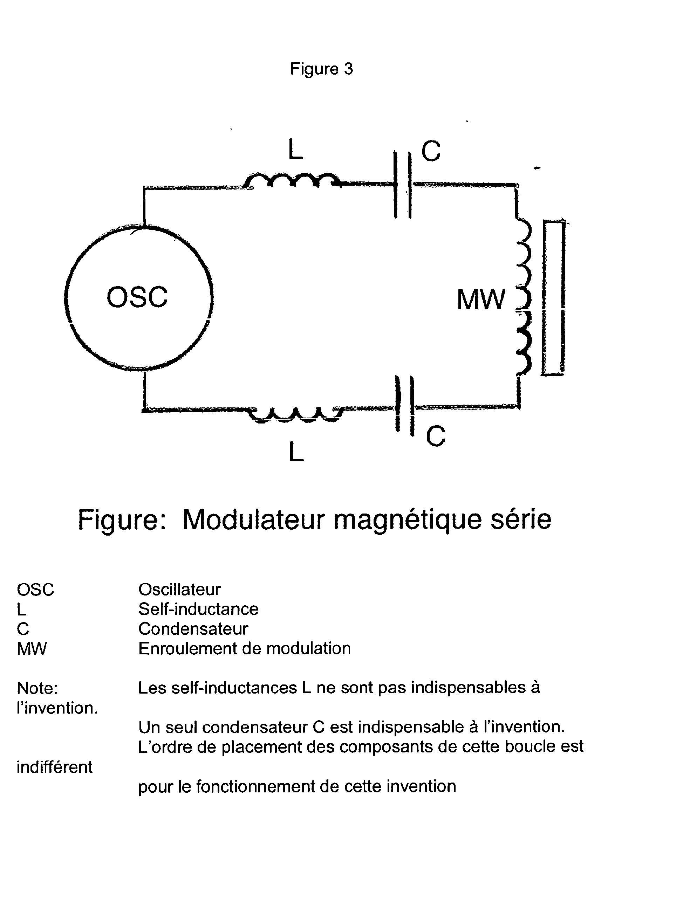

L'invention sera mieux comprise en références aux figures 2 et 3 qui suivent, données à titre d'exemples non limitatifs.

En référence à la figure 2 annexée, qui illustre un mode préféré de réalisation de l'invention, on constatera que l'invention ne nécessite que peu de composants électroniques; elle permet une réduction de coût de fabrication supérieure à 100 par rapport à l'état de l'art (Unser). Elle comprend un seul tore magnétique. De préférence, le tore est réalisé en matériau magnétique présentant la plus basse induction à saturation (Bs) possible, par exemple inférieure à 0,6 Tesla, comme par exemple un alliage amorphe de cobalt afin de limiter l'énergie nécessaire à la saturation du tore. Le tore est bobiné d'au moins trois enroulements. Un enroulement de modulation, un enroulement de perception du flux magnétique et un enroulement de contre-réaction. Elle consiste à bobiner le même nombre de tours pour chaque enroulement de façon jointive afin de diminuer le coût de fabrication. La modulation du tore magnétique est obtenue par un oscillateur à fréquence ajustable. Les filtres de démodulation ont une fréquence fixe. Une fréquence de modulation supérieure à 30 kHz permet d'éliminer l'intégrateur L/R. Elle est rendue possible par l'usage d'un tore à section magnétique inférieure à 1.2 mm².

La modulation magnétique du tore est réalisée par un courant de forme carrée, bipolaire, symétrique de rapport cyclique 50/50 dans l'enroulement de modulation.

Le circuit d'excitation de l'enroulement de modulation consiste en au moins un condensateur en série avec l'enroulement, contrairement à l'état de l'art qui préconise qu'un ou plusieurs condensateurs soient en parallèle avec l'enroulement. Avantageusement, au moins un condensateur est monté en série, dans un ordre quelconque, avec au moins une self-inductance à l'une ou aux deux extrémités de l'enroulement de modulation, En variante, telle que représentée en figure 3 annexée, l'enroulement de modulation comprend deux condensateurs et deux self-inductances, les self-inductances n'étant pas indispensables. Un seul condensateur est nécessaire et l'ordre de placement des composants de la boucle est indifférent.

Selon le mode de réalisation préféré, le filtrage de la seconde harmonique du signal de perception du flux est réalisé par une cascade de deux filtres à fréquence fixe: Un passe-haut et un passe-bas afin que la relation phase vs. fréquence --à la fréquence de seconde harmonique-- soit aussi stable que possible, contrairement à l'état de l'art qui préconise des filtres passe-bande. De plus, la relation de phase du signal est corrigée afin de compenser la dérive de phase due à l'effet d'une variation de température sur la magnétostriction de l'alliage du tore. La démodulation du signal issu de l'enroulement de perception du flux, notamment de la seconde harmonique, est réalisée par un redresseur synchrone à simple alternance afin d'en réduire le coût, contrairement à l'état de l'art qui préconise un redresseur à double alternance.

Le dispositif selon l'invention trouve de nombreuses applications, au nombre desquelles on pourra citer, à titre d'exemple non limitatif, le mesure des courants de fuites dans des appareillages ou instruments variés, tels que :
- panneaux photovoltïques
- appareils de chauffe de refroidissement ou de régularisation de température ou pression d'un fluide liquide, gazeux ou multiphase,
- appareils
ou pour mesure le courant de décharge de batteries de stockage d'électricité.

## Revendications

1. Dispositif de mesure de courant électrique isolé du courant à mesurer, capable de mesurer le courant avec une résolution inférieure à 1 mA, en particulier de l'ordre de 1 µA, **caractérisé en ce qu'**il comprend un seul tore pour la modulation, la perception du flux et la contre-réaction.

2. Dispositif de mesure selon la revendication 1, **caractérisé en ce que** le tore est modulé par une boucle de courant comportant l'enroulement de modulation et au moins un condensateur en série avec ce dernier.

3. Dispositif de mesure selon les revendications 1 et 2, **caractérisé en ce que** la résonance entre les inductances et capacitances de la boucle de modulation permettent une économie de l'énergie de modulation à concurrence du facteur de qualité de ladite résonance.

4. Dispositif de mesure selon la revendication 1 et une ou plusieurs des revendications 2 à 3, **caractérisé en ce que** la relation de phase entre le signal issu de l'enroulement de perception du flux et le signal de référence permettant sa démodulation est compensé de la dérive de mesure due à la température.

5. Dispositif de mesure selon la revendication 1 et une ou plusieurs des revendications 2 à 4, **caractérisé en ce que** la fréquence des filtres est fixe.

6. Dispositif de mesure selon les revendications 1 et 5, **caractérisé en ce que** la fréquence de modulation du tore est ajustable.

7. Dispositif de mesure selon les revendications 1, 2 et 3, **caractérisé en ce que** la section magnétique du tore est inférieure à 1.2 mm².

8. Dispositif de mesure selon les revendications 1 et 7, **caractérisé en ce que** le matériau magnétique du tore présente une induction de saturation inférieure à 0.6 Tesla.

9. Dispositif de mesure selon la revendication 1, **caractérisé en ce que** la démodulation du signal issu de l'enroulement de perception du flux est démodulé par un redresseur synchrone à une alternance.

10. Utilisation du dispositif de mesure selon l'une des revendications 1 à 10, pour mesurer régulation de la température ou de la pression d'un fluide liquide, gazeux ou multiphase.er la différence de courant aux bornes d'un appareillage susceptible de présenter une fuite de courant inférieure à 1 mA.

11. Utilisation selon la revendication 10, **caractérisé en ce que** l'appareillage susceptible de présenter une fuite de courant est un panneau photo-voltaïque.

12. Utilisation selon la revendication 10, **caractérisé en ce que** l'appareillage susceptible de présenter une fuite de courant est un appareil de chauffe, de refroidissement ou de régulation de la température ou de la pression d'un fluide liquide, gazeux ou multiphase.

13. Utilisation selon la revendication 10, **caractérisé en ce que** l'appareillage susceptible de présenter une fuite de courant est un appareil de conversion de l'énergie de l'hydrogène.

14. Utilisation selon la revendication 10, pour mesurer le courant de décharge de batteries de stockage d'électricité inférieur à 1 mA.
